# EUROPÄISCHE PATENTSCHRIFT

(11) **EP 0 704 786 B1**
(45) Veröffentlichungstag und Bekanntmachung des Hinweises auf die Patenterteilung: **12.11.1997**
(21) Anmeldenummer: 95113632.4
(22) Anmeldetag: 30.08.1995
(51) Int. Cl.: G06F 1/10, G06F 1/12

(54) **Schaltungsanordnung zur Störbefreiung eines Pulsrahmensignals**
Circuit for eliminating glitches from a framing signal
Circuit pour l'élimination de parasites dans un signal de trame

(30) Priorität: 23.09.1994 DE 4434085
(43) Veröffentlichungstag der Anmeldung: 03.04.1996
(73) Patentinhaber: SIEMENS AKTIENGESELLSCHAFT, 80333 München (DE)
(72) Erfinder: Prey, Gerhard, Ing.grad, D-82223 Eichenau (DE); Leitol, Stefan, Dipl.-Ing., D-81375 München (DE)

(56) Entgegenhaltungen:
- EP-A- 0 309 849
- EP-A- 0 601 777
- DE-A- 2 938 228

## Beschreibung

Die Erfindung betrifft eine Schaltungsanordnung zur Störbefreiung eines jeweils nach einer vorgegebenen Anzahl von Taktsignalimpulsen periodisch auftretenden digitalen Pulsrahmensignals.

Ein solches Pulsrahmensignal kann in Datenverarbeitungsanlagen mit einer Vielzahl von auf der Basis des Taktsignals arbeitenden Einheiten zur Synchronisation dieser Einheiten dienen.

In solchen Datenverarbeitungsanlagen wird der gemeinsame Takt an einer zentralen Stelle erzeugt bzw. eingespeist und über ein Taktverteilsystem verteilt, das unter Umständen beträchtliche Leitungslängen aufweist. Bei einem derartigen Verteilnetz besteht die Gefahr von durch Kopplungen während der Umschaltzeitpunkte der Taktsignalimpulse entstehenden Störungen, deren Amplituden die Schaltschwellen von Eingangsschaltungen der Einheiten übersteigen und damit die Gesamtfunktion der Anlage beeinträchtigen.

Soweit hiervon zwischen den Einheiten der Datenverarbeitungsanlage zu übertragende Daten betroffen sind, lassen sich solche Störungen durch Taktung der Datensignale ausblenden, indem die Informationsaufnahme der Empfänger mit der negativen Taktflanke erfolgt, so daß die mit der positiven Taktflanke entstehenden Störungen zum Übernahmezeitpunkt schon abgeklungen sind.

Für den Takt selbst und für das von ihm abgeleitete Pulsrahmen- bzw. Synchronisiersignal selbst kann diese Methode natürlich nicht angewendet werden. Bisher wurde daher in Fällen solcher Datenverarbeitungsanlagen das Verteilnetz für Takt- und Synchronisierimpulse durch entsprechende Entkopplungsmaßnahmen störunempfindlich gemacht bzw. durch Verwendung von störunempfindlichen Empfangsgattern die Auswirkungen von Störungen vermieden. Eine solche Lösung erfordert allerdings einen beträchtlichen Aufwand.

Die Aufgabe der Erfindung besteht daher darin, eine Schaltungsanordnung anzugeben, mit der solche von einem Taktsignal abgeleiteten Synchronisiersignale, deren Störbehaftung im System zu besonders nachteiligen Auswirkungen führt, von Störungen befreit werden, um mit vergleichsweise geringem Aufwand einen ordnungsgemäßen Datenverarbeitungsbetrieb gewährleisten zu können.

Eine Schaltungsanordnung gemäß der Lösung dieser Aufgabe weist die im Kennzeichen des Patentanspruchs 1 angegebenen Merkmale auf.

Nachstehend wird die Erfindung anhand eines Ausführungsbeispiels unter Bezugnahme auf eine Zeichnung naher erläutert.

In der Zeichnung zeigen:

Figur 1 als Beispiel für das Verteilsystem für Takt- und Synchronisierimpuls den Teil einer Datenverarbeitungsanlage in Form einer Fernsprechvermittlungsanlage, der ein solches Verteilsystem beinhaltet.

Figur 2 ein Impulsdiagramm einer Taktimpulsfolge und des davon abgeleiteten Synchronisiersignals.

Figur 3 ein Impulsdiagramm zur Veranschaulichung der durch die erfindungsgemäße Schaltungsanordnung zu eliminierenden Störungen eines Synchronisiersignals.

Figur 4 die erfindungsgemäße Schaltungsanordnung.

Figur 5 ein den Betrieb dieser Schaltungsanordnung charakterisierendes Impulsdiagramm.

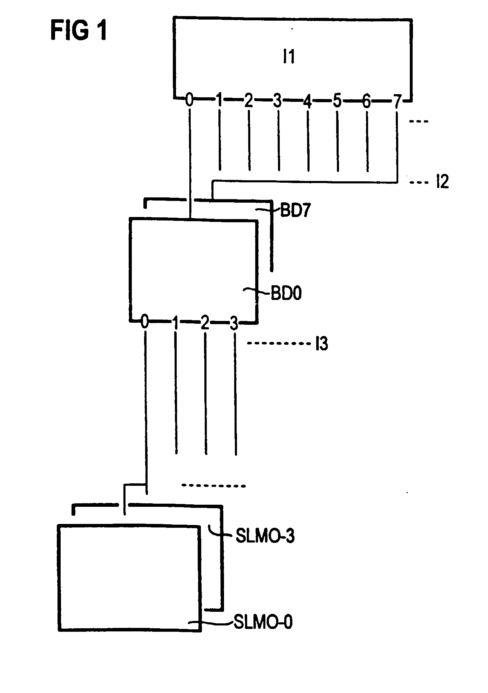

In der Figur 1 ist ein Teil einer Fernsprechvermittlungsstelle angedeutet, der deren Peripherie angehört. Es sind vier Anschlußgruppen SLMO-0 bis SLMO-3 gezeigt, an die Teilnehmeranschlußleitungen angeschlossen zu denken sind. Diese Anschlußgruppen enthalten eine entsprechende Anzahl von Teilnehmersätzen, sowie einen Anschlußgruppenprozessor.

Die genannten Anschlußgruppen sind Teil einer größeren Mehrzahl, die beispielsweise 128 betragen kann.

Die Figur 1 zeigt ferner eine zentrale Schnittstelleneinheit I1, über die der Datenaustausch mit den zentralen Teilen der Vermittlungsstelle erfolgt und über die die Anschlußbaugruppen mit Taktimpulsen und Synchronisiersignalen versorgt werden. Verteilereinheiten BD0 bis BD7 sorgen für eine teilzentrale Verteilung von Daten-, Takt- und Synchronisiersignalen. Sie bilden eingangsseitig eine Schnittstelle I2 und ausgangsseitig eine Schnittstelle I3. Der Ausgang 0 des zur Verteilereinheit BD0 gehörigen Teils der Schnittstelle I3 führt, wie dargestellt, zu den gezeigten Anschlußeinheiten SLMO-0 bis SLMO-3. Die übrigen Ausgänge dieser Verteilereinheit bzw. die Ausgänge der übrigen Verteilereinheiten führen zu hier nicht dargestellten weiteren Anschlußeinheiten.

Die Verbindungen des dargestellten Verteilernetzes mögen der Verteilung der Synchronisationssignale dienen. Entsprechende Verbindungen sind für den Takt und die Daten zu denken.

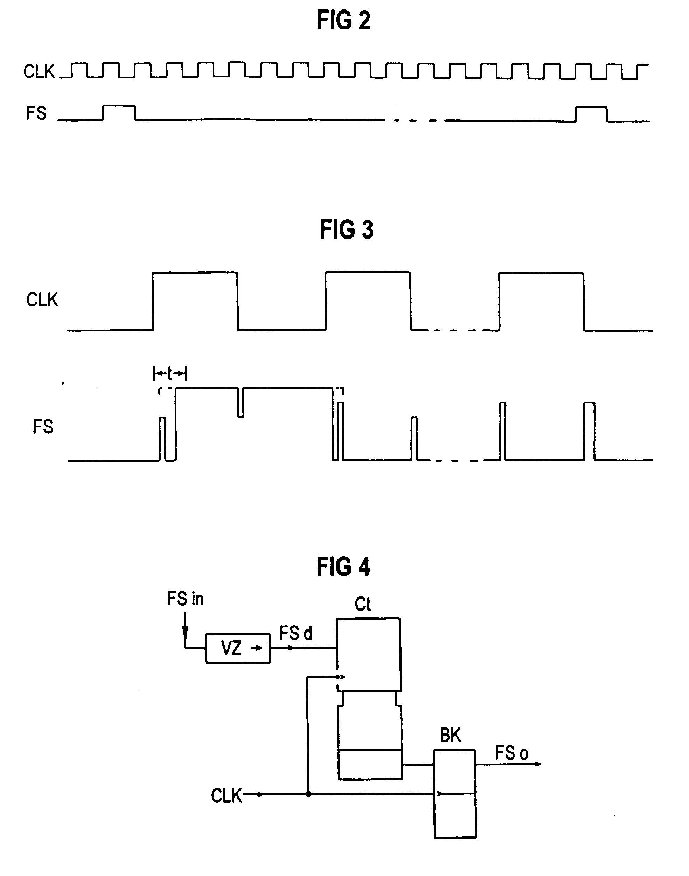

Das Impulsdiagramm der Figur 2 zeigt die zeitliche Relation der Taktimpulse CLK und des als Synchronisiersignal eingesetzten Pulsrahmensignals FS, das in einem in der Praxis realisierten Fall jeweils am Anfang eines 512 Taktimpulsperioden umfassenden Pulsrahmens steht. Pro Taktimpulsphase kann ein Bit der Nutzdaten von und zu den Anschlußgruppen übertragen werden.

In der Figur 3 sind nochmals Taktimpulse und Synchronisiersignale in vergrößertem Maßstab dargestellt, wobei diese störbehaftet sind. Die Figur zeigt, daß mit Flankenwechseln der Taktimpulse CLK Störungen des Synchronisiersignalimpulses entstehen können, indem sowohl bei der Vorderflanke als auch bei der Rückflanke wie auch im Mittenbereich schmale Störimpulse auftreten, die nicht die volle Signalamplitude erreichen. Auch während der Impulspause der Synchronisierimpulsfolge FS treten solche Störimpulse auf.

Die erfindungsgemäße Schaltungsanordnung dient nun dazu, die Synchronisierimpulse von solchen Störimpulsen zu befreien. Voraussetzung für das Funktionieren dieser Schaltungsanordnung ist ein störungsfreier Verlauf der Taktimpulsfolge. Sollten die Taktimpulse ihrerseits an Vorder- und Rückflanke Störimpulse aufweisen, so muß für eine Störbefreiung des Taktes gesorgt werden, wozu eine Schaltungsanordnung dient, die Gegenstand einer weiteren Patentanmeldung ist.

Die erfindungsgemäße Schaltungsanordnung gemäß Figur 4 besteht aus einem Zähler Ct, der durch die Abfallflanke der Taktimpulse CLK weitergeschaltet wird und bei der gemäß Figur 2 vorausgesetzten Pulsrahmenlänge nach 512 Taktimpulsen ein Ausgangssignal abgibt.

Das unter Umständen störbehaftete Synchronisiersignal FS, wie es beim Verteilnetz gemäß Figur 1 an der Schnittstelle I2 auftritt, wird diesem Zähler über ein Verzögerungsglied VZ als Rücksetzsignal zugeführt. Die Verzögerungszeit des Verzögerungsgliedes entspricht der Zeitspanne, nach der ein mit dem Flankenwechsel der Taktimpulse CLK beginnende Störung des Synchronisiersignals FS abgeklungen ist und beträgt beispielsweise 75 nsec. Dem Zähler Ct ist eine mit der Anstiegsflanke der Taktimpulse CLK geschaltete taktflankengesteuerte bistabile Kippstufe BK nachgeschaltet, der das Ausgangssignal des Zählers Ct als Eingangssignal zugeführt wird und deren Ausgangssignal das störbefreite Pulsrahmensignal bzw. Synchronisiersignal darstellt.

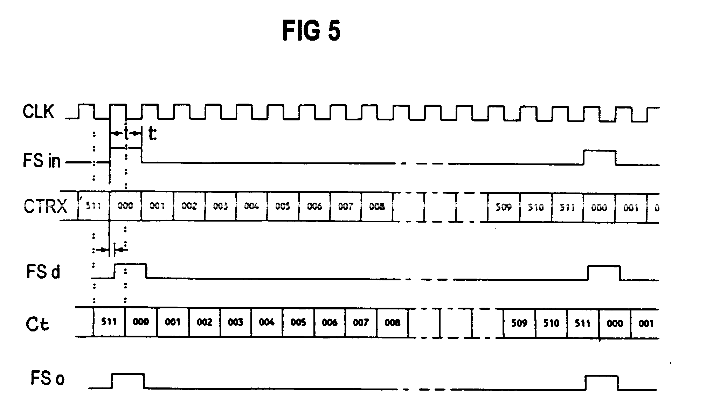

In der Figur 5 sind in der oberen Hälfte neben der Taktimpulsfolge CLK das an der Schnittstelle I2 auftretende störbehaftete Pulsrahmensignal FSin, sowie die Zählerstände eines Zählers CTRX für den Takt dargestellt, mit dessen Hilfe das Synchronisiersignal vom Takt abgeleitet wird.

In der unteren Hälfte zeigt die Figur 5 ferner den Zeitverlauf des durch das Verzögerungsglied VZ verzögerten Pulsrahmensignals FSd, die Zählerstände des Zählers Ct sowie das Ausgangssignal FSo der bistabilen Kippstufe BK, das das störbefreite und im vorliegenden Anwendungsfall der erfindungsgemäßen Schaltungsanordnung an der Schnittstelle I3 auftretende störbefreite Synchronisiersignal darstellt.

Da der Zählerstandwechsel in den Zählerstand 000 des Zählers Ct aufgrund der Rückstellung durch das verzögerte Pulsrahmensignal FSd erst mit der abfallenden Flanke eines Taktimpulses CLK erfolgt, ist zu diesem Zeitpunkt die Störung der Vorderflanke des verzögerten Pulsrahmensignals FSd bereits abgeklungen. Wegen der Verzögerung des Pulsrahmensignals FSd gegenüber den ankommenden Pulsrahmensignal FSin fällt dieser Zustandswechsel nicht mit dem durch die abfallende Flanke des Taktimpulses bedingten Störung, wie sie Figur 3 zeigt, zusammen, der Umschaltvorgang des Zählers kann also hiervon unbeeinflußt stattfinden. Die störbehaftete Abfallflanke des verzögerten Pulsrahmensignals FSd tritt ebenfalls vor dem mit Auftreten der nächsten Abfallflanke eines Taktimpulses CLK stattfindenden Wechsel des Zählers in den Zählerzustand 001 auf und kann diesen daher ebenfalls nicht störend beeinflussen.

Das Signal, das am Ausgang des Zählers Ct mit Erreichen des Zählerstandes 511 auftritt, bereitet die bistabile Kippstufe BK für eine Umschaltung vor, die nun jedoch mit der Anstiegsflanke eines Taktimpulses CLK erfolgt, so daß bei zyklischer Wiederholung der beschriebenen Vorgänge am Ausgang dieser bistabilen Kippstufe tatsächlich im Abstand von 512 Taktimpulsen ein nun störbefreites Pulsrahmensignal FSo auftritt.

Für den Fall, daß das Pulsrahmensignal in der Weise gestört ist, daß es völlig ausbleibt, kann vorgesehen sein, die beschriebene Schaltungsanordnung derart zu ergänzen, daß auch die Abgabe des Ausgangssignals der bistabilen Kippstufe BK, also das Signal FSo, unterbunden wird. Eine Störung des Pulsrahmensignals FS in der Form, daß dieses als Dauersignal auftritt, führt dazu, daß der Zähler Ct blockiert wird. In beiden Fällen lassen sich die Fehlerreaktionen zur Fehlererkennung auswerten. Bei einem Einsatz der erfindungsgemäßen Schaltungsanordnung gemäß Figur 1 besteht dann die Möglichkeit auf ein vorhandenes gedoppeltes Taktverteilsystem umzuschalten.

## Patentansprüche

1. Schaltungsanordnung zur Störbefreiung eines jeweils nach einer vorgegebenen Anzahl von Taktimpulsen periodisch auftretenden digitalen Pulsrahmensignals, **gekennzeichnet** durch einen von der Abfallflanke der Störungsfreien Taktimpulse (CLK) weitergeschalteten und nach Auftreten von Taktimpulsen in der vorgegebenen Anzahl ein Ausgangssignal abgebenden Zähler (Ct), dem das störbehaftete Pulsrahmensignal (FSin) über ein Verzögerungsglied (VZ), dessen Verzögerungszeit der Zeitspanne entspricht, nach der eine mit dem Flankenwechsel der Taktimpulse beginnende Störung des Pulsrahmensignals abgeklungen ist, als Synchrones Rücksetzsignal (FSd) zugeführt wird, sowie durch eine mit der Anstiegsflanke der Taktimpulse geschaltete taktflankengesteuerte bistabile Kippstufe (BK), der das Ausgangssignal des Zählers als Eingangssignal zugeführt wird und deren Ausgangssignal das störbefreite Pulsrahmensignal (FSo) darstellt.

2. Schaltungsanordnung nach Anspruch 1, **dadurch gekennzeichnet,** daß bei Ausfall des Pulsrahmensignals die Weitergabe des Ausgangssignals (FSo) der bistabilen Kippstufe unterbunden wird.

## Claims

1. Circuit arrangement for eliminating glitches from a digital pulse frame signal which periodically occurs in each case after a predetermined number of clock pulses, characterized by a counter (Ct) which is advanced by the falling edge of the glitch-free clock pulses (CLK), emits an output signal after the occurrence of the predetermined number of clock pulses and to which the perturbed pulse frame signal (FSin) is fed as synchronous reset signal (FSd) via a delay element (VZ), whose delay time corresponds to the time interval after which a glitch, which begins at the edge change of the clock pulses, in the pulse frame signal has decayed, and also by an edge-triggered bistable multivibrator (BK) which is switched by the rising edge of the clock pulses and to which the output signal of the counter is fed as input signal and whose output signal represents the pulse frame signal (FSo) from which glitches have been eliminated.

2. Circuit arrangement according to Claim 1, characterized in that, in the event of failure of the pulse frame signal, the forwarding of the output signal (FSo) of the bistable multivibrator is stopped.

## Revendications

1. Montage pour l'élimination des parasites d'un signal numérique de trame apparaissant périodiquement, chaque fois après un nombre prédéfini d'impulsions d'un signal d'horloge,
**caractérisé** par un compteur (Ct) qui avance d'un cran sur le flanc négatif des impulsions d'horloge non parasitées (CLK), qui délivre, après le nombre prédéfini d'impulsions d'horloge, un signal de sortie et sur lequel le signal de trame parasité (FSin) est appliqué, en tant que signal synchrone de remise à zéro (FSd), à travers un élément de temporisation VZ dont la constante de temps correspond à la période de temps après laquelle un parasite du signal de trame commençant au niveau du changement de flanc des impulsions d'horloge est amorti, ainsi que par un circuit bascule bistable (BK) dont la commutation est commandée par le flanc positif des impulsions d'horloge, sur lequel est appliqué, comme signal d'entrée, le signal de sortie du compteur et dont le signal de sortie constitue le signai de trame déparasite (FSo).

2. Montage conforme à la revendication 1
**caractérisé par le fait** que, en cas de disparition du signal de trame, la transmission du signal de sortie (FSo) du circuit bascule bistable est interrompue.
